# EUROPEAN PATENT APPLICATION

(11) **EP 2 169 788 A1**
(43) Date of publication of application: **31.03.2010**
(21) Application number: 08290918.5
(22) Date of filing: 30.09.2008
(51) Int. Cl.: H01S 5/022, G02B 6/122, G02B 6/124, H01S 5/12, H01S 5/00, H01S 5/14

(54) **Wavelength selective element, process for adjusting the refraction index of a wavelength selective element, and optical radiation emitting component**

(71) Applicant: Alcatel Lucent, 75008 Paris (FR); Fraunhofer-Gesellschaft zur Förderung der angewandten Forschung e.V., 80686 München (DE); MergeOptics GmbH, 13507 Berlin (DE); Koeth, Johannes, 97218 Gerbrunn (DE); Bayerische Julius-Maximilians-Universität Würzburg, 97074 Würzburg (DE)
(72) Inventor: Pfeiffer, Thomas, 70569 Stuttgart (DE); Templ, Wolfgang, 74372 Sersheim (DE); Koeth, Johannes, 97218 gerbrunn (DE); Kamp, Martin, 97218 Gerbrunn (DE); Houbertz-Krauss, Ruth, 97440 Werneck (DE); Domann, Gerhard, 97204 Höchberg (DE); Schulz, Klaus, 12309 Berlin (DE)
(74) Representative: Brose, Gerhard

(57) **Abstract**

The invention relates to a wavelength selective element (BR;LC,GR) having a grating structure (BR;GR), for a component (10,20) for emitting optical radiation, in which the characteristic wavelength as defined by the grating structure (BR;GR) is influenced by the materials properties of the grating structure (BR;GR). wherein the grating structure (BR;GR) comprises a material, the refraction index of which is adjustable permanently by means of a temporary energy input, to a process for adjusting the refraction index of a wavelength selective element (BR;LC,GR) and to an optical radiation emitting component (10,20). The wavelength selective element may be included in a laser to form a DFB or DBR laser. The energy may be input as UV light. An UV LED may be provided inside the laser housing for adjusting the laser wavelength in a post-fabrication process.

## Description

The invention relates to a wavelength selective element having a grating structure, according to the preamble of claim 1, to a process for adjusting the refraction index of a wavelength selective element, according to the preamble of claim 3, and to an Optical radiation emitting component, according to the preamble of claim 6.

Most of today's optical fiber links employ a wavelength division multiplexing (WDM) scheme where multiple channels, each with a distinct wavelength, are transmitted over a single fiber. The preferred light sources for these WDM systems are semiconductor lasers since they have a very compact size, a high efficiency and a large modulation bandwidth. The lasers have to operate on a single mode, emitting one spectral line with a power that is several orders of magnitude larger than that of the sidemodes. Furthermore, the wavelength of each laser has to stay in an allocated wavelength interval during its lifetime in order to prevent interference with neighboring channels.

The traditional way to realize a single-mode semiconductor laser is the monolithic incorporation of a wavelength selective element in the laser cavity. This element leads to a discrimination of the preferred laser mode with respect to all other modes by decreasing the threshold gain of the laser mode and/or by increasing the threshold gain of the undesired competing modes. Structures, which are commonly used, are based on feedback gratings, which are either placed at the end of the laser resonator in order to realize a wavelength selective reflector (distributed Bragg reflector, DBR) or along the laser cavity (distributed feedback lasers, DFB). In case of the DFB laser, the feedback gratings can couple to the optical mode either via a modulation of the refractive index (index coupled DFB) or the gain (gain coupled DFB). The latter are sometimes also called complex coupled DFB lasers since a modulation of the gain usually involves a modulation of the refractive index as well.

In any case, the emission wavelength lambda of the laser is related to the grating period d and the effective refractive index n_eff by the simple relation lambda = 2*n_eff*d. The effective refractive index is a weighted average over the individual refractive indices of the layers that make up the device.

The number of channels in a WDM system can be quite large, so economical solutions to the question of how to fabricate and stock lasers for all the channels are of great interest. One solution is the use of tunable lasers, which can cover all or a part of the transmission channels in a transmission system. Since the grating period d is fixed during the fabrication process, the only way to change the emission wavelength is to change the effective refractive index n_eff. In case of semiconductors, the refractive index can be changed by a variation of the temperature or the carrier density. The temperature dependence of the refractive index is typically around 5*10_exp(-4) K_exp(-1). Since the performance of semiconductor lasers degrades at elevated temperatures and standard Peltier coolers have a lower temperature limit that can be reached, the temperature range which can be used for tuning is around 100 K, leading to a shift of the refractive index in the order of 5*10_exp(-2), corresponding to a wavelength shift of about 8 nm in the wavelength range around 1.5 µm.

The coefficient for a carrier-induced shift of the refractive index is about 10_exp(-20)cm_exp(3). Carrier densities around 10_exp(18)cm_exp(-3), which are readily achieved by electrical injection, therefore lead to a shift of the refractive index of 10_exp(-2). In contrast to the case of temperature tuning, where the refractive index of all the layers in the lasers is affected, the index change caused by current injection is restricted to the waveguide core of the laser. The effect on the effective refractive index has to be weighted with the confinement factor, which is the fraction of the guided mode that is located in the waveguide core. Collecting all the numbers one arrives at a shift of the effective index of about 2-3*10_exp(-3), corresponding to a wavelength shift of up to 5 nm. The two tuning mechanisms can be combined to a certain extent, resulting in a tuning range around 10 nm or slightly larger.

However, this is not sufficient to tune the laser over an entire transmission band (delta_lambda appr. 50 nm) of an optical fiber system. In order to increase the tuning range, some additional leverage has to be used. A common way is to use multiple gratings with multiple reflection peaks, leading to a Vernier effect that translates small shifts of a reflection peak into a large shift of the laser emission. The drawback of these devices is the rather complicated layout with multiple segments and contacts and a correspondingly complex control circuitry, involving look-up tables and multiple current sources. While these devices are getting more and more important in long haul, high performance networks, the requirements in access networks are entirely different.

In this case, a dynamic tunability of the sources is not required; it is sufficient to fix the emission wavelength once during the installation. Since cost issues are of major importance in the access market, solutions where the devices are operated from a single current source and don't require additional circuitry are preferred.

This problem according to the invention is solved by a wavelength selective element according to the teaching of claim 1, by a process according to the teaching of claim 3, and by an optical radiation emitting component according to the teaching of claim 6.

The invention uses the fact that there exist materials whose parameters, especially the refraction index, can be varied permanently and definitely by temporary energy input. Optical devices containing elements with such materials can be adjusted on site.

Further embodiments of the invention are to be found in the subclaims and in the following description.

In the following the invention will be described in more detail with the aid of the accompanying drawings, in which:
- Figure 1: shows a first embodiment of an optical radiation emitting component according to the invention with a wavelength selective element according to the invention enabling radiation wavelength adjustment by means of a process according to the invention.
- Figure 2: shows a second embodiment of an optical radiation emitting component according to the invention with a wavelength selective element according to the invention enabling radiation wavelength adjustment by means of a process according to the invention.

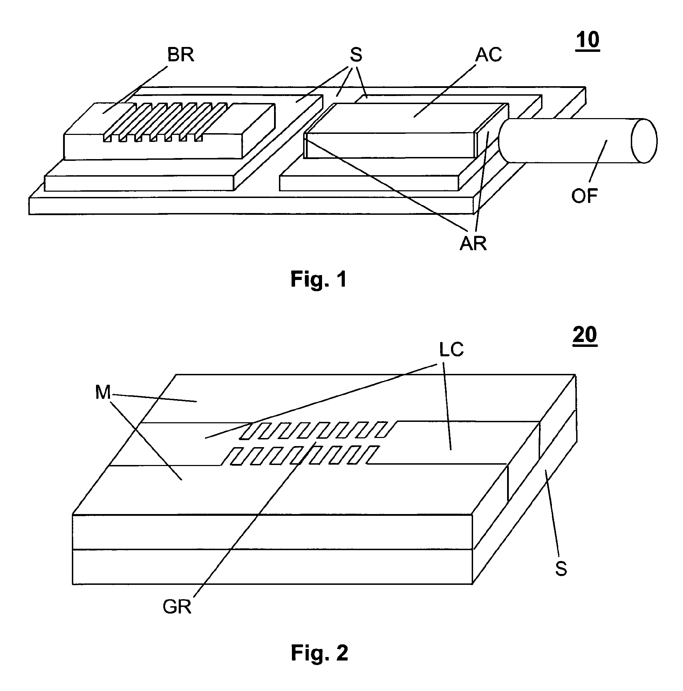

Figure 1 shows a component 10, which involves a distributed Bragg reflector BR, or DBR, as wavelength selective element. Two separate substrates S are carried by a common substrate S. A Bragg reflector BR with a grating structure, an amplifier chip AC, and an optical fiber OF are arranged along an optical axis. The amplifier chip AC carries antireflective coatings AR both, at the side turned versus the Bragg reflector, and at the side turned versus the optical fiber. Reflectivity of the front facet is kept sufficiently low in order to suppress laser operation; hence the component performs amplified spontaneous emission (ASE) of light. The Bragg reflector is made out of a material, the reflection index of which in combination with the grating structure defines the wavelength characteristic of the reflector and, together with the dimensions of the amplifier chip, the wavelength of the light to be emitted into the optical fiber. Such material normally is a suitable polymer.

The invention now uses the fact that it is possible to use hybrid structures, consisting of semiconductor layers that provide the optical gain and bragg gratings made from materials whose refractive index can be tuned in a post-fabrication process, e.g. by adjusting the degree of cross-linking, e.g. by irradiation of UV-light. The semiconductor based gain section would be operated with a single control current and the refractive index of the material would determine the emission wavelength without the need for any additional control circuitry.

An example of a material with such feature is known from EP1834977A1.

For practical application in a transmission system such optical radiation emitting component is placed inside an optical sub-assembly incorporating said component having a grating structure as described above and an additional light source that is used for adjusting the refractive index of the material that forms the grating structure. During production the effective grating period is designed to approximately match the Bragg condition for the required emission wavelength of the device. When the laser is to be set into operation in the network, the additional light source, preferably an UV LED, is temporally activated to permanently modify the index of the polymer material. Depending on the intensity and duration of this illumination the effective index of the waveguide grating in the Bragg reflector BR can be fine-tuned to the exact value that is required for the desired emission wavelength of the laser.

This curing process may be supported by additional, temporally applied energy injection, e.g. heating. After switching off the UV light source and the potentially applied additional energy source the polymer keeps the modified index value and hence the laser permanently emits at the desired wavelength without additional controls. The polymer material has to be chosen from a suitable class of materials to allow for efficient modification of the refractive index in the wavelength region of interest (for optical transmission systems typically in the range 1260 - 1600 nm or within parts of that range) and with affordable amounts of auxiliary light (e.g. UV) energy.

Figure 2 shows an other component 20 akin to a distributed feedback laser, or DFB. On a substrate S a laser cavity LC having a grating structure GR in the middle section is embedded into a matrix M. In this example the grating GR consists of a double-sided comb structure left within the laser cavity LC and fingers extending from the matrix M into the comb structure of the laser cavity LC. The fingers are made of the same material as the matrix M and not separated therefrom. It is the sole purpose of the matrix M to carry said fingers, which otherwise hardly could be fabricated.

Also in this example the material of the wavelength-selective structure, namely of the matrix and the fingers extending therefrom into the laser cavity, is chosen according to the invention and the adjusting process is performed as described above.

The above-described components 10 or 20 (DBR or DFB) finally are mounted on a metallized and structured sub-mount, which is prepared with electrical contacts to drive the light source and optical path to couple the light into fiber for transmission. This sub-mount is the base for a transmitter optical subassembly (TOSA) with separated housing (e.g. acc. XMD-MSA or TO-can) or direct mounted on the PCB of a transceiver module. In dependency of these applications are two methods to bring the UV light to the polymer: internal source or external source. The emission wavelength is in all cases measured in situ by operating the components 10 or 20 (DBR, DFB).
1. Internal source: UV LED is inside the housing mounted on the cap and contacted with feedthroughs to operate the LED from outside to initiate the curing process.
2. External source: The cap has an integrated window and the curing process will be initiated by an external UV source. After achievement of the expected emission wavelength and switch off the UV light, the windows must be coated with an intransparent layer to prevent unexpected light.
3. In case of direct mounting of the sub mount on the PCB of a transceiver module the curing can be initiated by external UV source only. After achievement of the expected emission wavelength and switch off the UV light, the area of DBR/DFB must be coated with an intransparent glob top to prevent unexpected light.

The idea of using materials whose parameters, especially the refraction index, can be varied permanently by temporary energy input, according to the invention can be applied to any known or not yet known structure of wavelength selective elements or optical radiation emitting components comprising structural parts that may be made out of such material.

## Claims

1. Wavelength selective element (BR; LC, GR) having a grating structure (GR), for a component (10, 20) for emitting optical radiation, in which the characteristic wavelength as defined by the grating structure (BR; GR) is influenced by the materials' properties of the grating structure (BR; GR), **characterized in, that** the grating structure (BR; GR) comprises a material, the refraction index of which is adjustable permanently by means of a temporary energy input.

2. Wavelength selective element (BR; LC, GR) according to claim 1, **characterized in, that** the grating structure (BR; GR) occupies the element (BR; LC, GR) only in part.

3. Process for adjusting the refraction index of a wavelength selective element (BR; GR) according to claim 1, **characterized in, that** energy is input until the specified refraction index is reached.

4. Process according to claim 3, **characterized in, that** the energy is input as UV light.

5. Process according to claim 4, **characterized in, that** additional energy is input as heat.

6. Optical radiation emitting component (10, 20) with an element for generating and amplifying the optical radiation (AC; LC) and a wavelength selective element (BR; LC, GR), **characterized in, that** the wavelength selective element (BR; LC, GR) is of the sort as claimed in claim 1.

7. Optical radiation emitting component (10) according to claim 6, **characterized in, that** the element for generating and amplifying the optical radiation (AC) is arranged between the wavelength selective element (BR) and an optical output (OF), and that the wavelength selective element (BR) is build as wavelength selective reflector (BR).

8. Optical radiation emitting component (20) according to claim 6, **characterized in, that** the wavelength selective element (GR) is embedded into the element for generating and amplifying the optical radiation (LC).
